Europäisches Patentamt

European Patent Office

Office européen des brevets

(19)

(11) Publication number: **0 202 565**

**A1**

(12) **EUROPEAN PATENT APPLICATION**

(21) Application number: **86106395.6**

(51) Int. Cl.⁴: **H05K 5/00**

(22) Date of filing: **12.05.86**

(30) Priority: **16.05.85 IT 2182785 U**

(43) Date of publication of application:
**26.11.86 Bulletin 86/48**

(84) Designated Contracting States:
**DE FR GB NL**

(71) Applicant: **GEWISS S.p.A.**
**Via Provinciale 61**
**I-24069 Cenate Sopra (Bergamo)(IT)**

(72) Inventor: **Bosatelli, Domenico**
**Via degli Alpini**
**I-24069 Cenate Sotto Bergamo(IT)**

(74) Representative: **Modiano, Guido et al**
**MODIANO, JOSIF, PISANTY & STAUB**
**Modiano & Associati Via Meravigli, 16**
**I-20123 Milan(IT)**

(54) **Closure device functioning as a hinge, particularly for electric component cabinets.**

(57) Closure device functioning as a hinge, particularly for electric component cabinets, which comprises a threaded seat (2), defined by a box-type body (1), wherein the threaded shank (21) is engageable of a screw element (20) having a spherical head (22), receivable in a spherical seat (12) defined by a cover element (10) coupleable with the box-type body (1). To the seat (12) is led an introduction conduit (13) for the screw element extending substantially perpendicularly to the plane of lay of the cover element (10) and one side cutout (15) engageable with a terminating portion of the threaded shank (21), on using the closure device as a hinge.

*Fig. 2*

# "CLOSURE DEVICE FUNCTIONING AS A HINGE, PARTICULARLY FOR ELECTRIC COMPONENT CABINETS"

This invention relates to a closure device functioning as a hinge, particularly for electric component cabinets.

In a prior Patent application by the same applicant (Italian Patent application N. 25069 A/76 filed on July 6, 1976), which is incorporated herein by reference, there is disclosed a panel cabinet for electric components which has, inter alia, a front panel connected to the box-type body by screw fasteners adapted to also function both as closure elements and hinge elements for rotation about a substantially parallel axis to one of the panel sides.

In the embodiment disclosed in the cited patent application, the screw fasteners comprise essentially a self-tapping screw which engages in a diametrical hole formed in a pawl accommodated in a seat formed in the box-type body.

The cited seat is open at its lateral zone such that, on using the screw fasteners as hinge elements, the fastener can be loosened and rotation around the pawl then performed.

This embodiment, which has shown to be effective from several standpoints, is susceptible to improvement especially as regards its implementation and speed of assembly.

It is the aim of this invention to eliminate the limitations set forth above by providing a closure device whereby the hinge function can be afforded without providing a number of mutually assemblable elements.

Within the above aim, it is a particular object of the invention to provide a closure device which can comprise in practice a single element capable of performing both as a hinge and as a closure element, thus facilitating assembly and greatly simplifying all the constructional features.

Another object of this invention is to provide a closure device whose operation is extremely practical and fast, thus facilitating use of the electric component cabinet incorporating it.

A not least object of this invention is to provide a closure device which can be easily formed from readily available materials on the market, and which can be advantageous cost-wise.

The above aim, and these and other objects to become apparent hereinafter, are achieved by a closure device functioning as a hinge, particularly for electric component cabinets, according to the invention, characterized in that it comprises a threaded seat, defined by a box-type body, whereinto the threaded shank is engageable of a screw element having a substantially spherical head removably receivable in a substantially spherical seat defined by a cover element coupleable with said box-type body, to said seat there being led an introduction conduit for said screw element extending substantially perpendicularly to the plane of lay of said cover element and a side cutout engageable with a terminating portion of said threaded shank on using the closure device as a hinge.

Further features and advantages will be more clearly apparent from the following detailed description of a closure device with hinge function, particularly for electric component cabinets, shown by way of illustration and not of limitation in the accompanying drawing, where:

Figure 1 shows diagrammatically a perspective view of a cabinet for electric components incorporating this closure device;

Figure 2 is an exploded sectional view of the closure device;

Figure 3 shows, in section, the closure device in its closed position;

Figure 4 shows, in section, the device as positioned for use as a hinge;

Figure 5 is a view taken along the line V-V of Figure 2;

Figure 6 is a side elevation view of the device in the closed position;

Figure 7 shows the screw element in its withdrawn position for use as a hinge; and

Figure 8 is a side elevation view of the device in the open position with the screw element being used as hinge.

With reference to the drawing figures, a closure device with hinge function, particularly for electric component cabinets, according to the invention, comprises a threaded seat 2 which is defined close to the corners of a box-type body for electric components, which is generally designated 1.

Advantageously, in a preferred embodiment, the threaded seat 2 is of the through-going type and the thread formation comprises a thread 3 which extends through substantially one pitch length, thereby facilitating the box-type body moulding steps.

To the box-type body 1 there may be attached a closure cover, generally indicated at 10, which may have a peripheral sealing gasket 11 which engages with the box-type body.

In the cover 10, aligned to the threaded seats 2, there is formed a substantially spherical seat, indicated at 12.

The seat 12 has an introduction conduit 13 which extends preferably along a perpendicular direction to the plane of lay of the cover 10.

The conduit 13 allows introduction of a screw element 20 which has a threaded shank 21 engageable in the threaded seat 2 and being terminated with a substantially spherical head 22 which is adapted to fit into the substantially spherical seat 12.

The head 22 has in its upper portion a recessed seat 23 for engagement by a screwdriver or the like tool.

The shank 21 is connected to the head 22 by a cylindrical section 24.

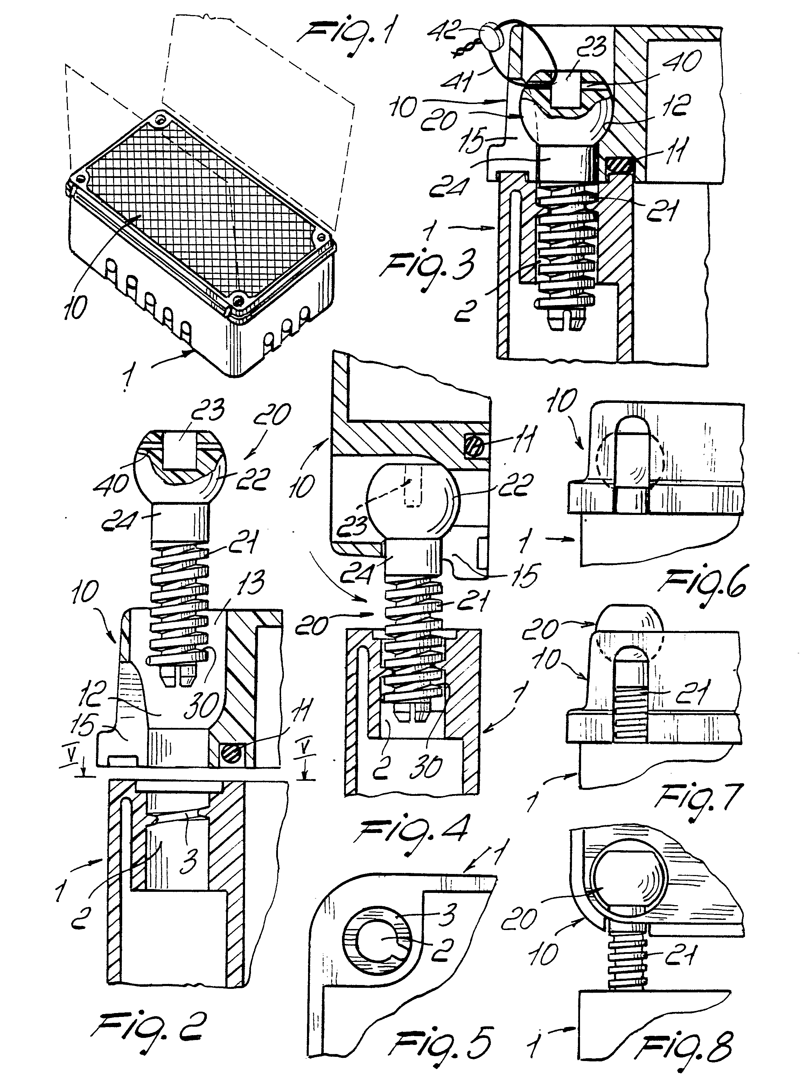

As described previously, the screw element 20 is adapted to engage in the threaded seat 2 effecting, as shown in Figure 3, the closure tightening between the cover and box-type body.

The seat 12 has, in a lateral zone thereof, a cutout 15 which is open towards the box-type body so that the screw section close adjoining the head 22 can engage in the cutout 12 when the closure device is used as a hinge. It is also possible to arrange for a second cutout at 90° to the former, for permitting hinge opening of the cover about all the sides of the box-type body.

As diagrammatically represented in Figure 4, to use the device as a hinge, it will be sufficient to loosen the screw element 20 enough to move the spherical head 22 away from the edge of the box-type body.

In this position, it becomes possible to effect a rotation of the cover with engagement of the cylindrical section 24 in the side cutout 15 by utilising the head 22-to-seat 12 coupling.

It should be further added to the foregoing that the threaded shank 21 has at the end of its thread an enlargement, generally indicated at 30, which, on engaging with the thread 3, acts as a stop element to prevent the screw element 20 from incidentally slipping off the seat 2.

This is of considerable importance in achieving proper positioning of the screw element 20 to use the closure device in the hinge mode.

In the event that the connection is to be removed, slight forcing in threading out will be sufficient such that the screw element is allowed to come off the threaded seat 2.

It should be added to the foregoing that there may be provided on the head 12 through holes 40 through which a thread or small chain 41 may be passed for application of a lead seal 42.

It may be appreciated from the foregoing description that the invention achieves the objects set forth, and in particular that a closure device is provided which is obtained through a single element consisting of the screw element with its substantially spherical head, which affords considerably simpler making and assembling operations, as well as improving operability of the closure device itself.

In practicing the invention, the materials used, as well as the dimensions and contingent shapes, may be any ones required.

**Claims**

1. A closure device functioning as a hinge, particularly for electric component cabinets, characterized in that it comprises a threaded seat (2) defined by a box-type body (1), wherein the threaded shank - (21) is engageable of a screw element (20) having a substantially spherical head (22) removably receivable in a substantially spherical seat (12) defined by a cover element (10) coupleable with said box-type body (1), to said seat (12) there being led an introduction conduit (13) for said screw element (20) extending substantially perpendicularly to the plane of lay of said cover element (10) and at least one side cut-out (15) engageable with a terminating portion of said threaded shank (21) on using the closure device as a hinge.

2. A closure device according to the preceding claim, characterized in that said substantially spherical head (22) of said screw element (20) has a recessed seat (23) adapted to be reached from said introduction conduit.

3. A closure device according to the preceding claims, characterized in that said threaded seat (2) has a thread (3) which extends substantially over one pitch length.

4. A closure device according to one ore more of the preceding claims, characterized in that the thread formation on said threaded shank (21) has, at the free end thereof, an enlargement (30) adapted to function as a stop element for the engagement with said thread (3) of said threaded seat (2) to prevent said screw element (20) from incidentally disengaging from said threaded seat (2).

5. A closure device according to one or more of the preceding claims, characterized in that said side cutout (15) is apertured at the face of said cover facing said box-type body.

6. A closure device according to one or more of the preceding claims, characterized in that it comprises through holes (40) in said spherical head - (22) for introduction of a thread or small chain (41) for application of a lead seal (42).

Fig.1

Fig.3

Fig.2

Fig.4

Fig.5

Fig.6

Fig.7

Fig.8

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y,D | FR-A-2 358 079  (GEWISS S.p.A.)<br>* Whole document *<br>---  | 1,5 | H 05 K    5/00 |
| Y | FR-A-  981 267  (AEROPLANES H. POTEZ)<br>* Abstract *<br>--- | 1,5 | |
| A | DE-U-7 233 686  (ROBERT BOSCH)<br>* Figure 4; page 5, lines 12-19 *<br>--- | 6 | |
| A | FR-A-1 541 586  (HAZEMEIJER)<br>* Figures 1,2 *<br><br>----- | 1 | |

TECHNICAL FIELDS
SEARCHED (Int. Cl.4)

H 05 K
E 05 D

The present search report has been drawn up for all claims

| Place of search | Date of completion of the search | Examiner |
|---|---|---|
| THE HAGUE | 18-08-1986 | TOUSSAINT F.M.A. |